# EUROPÄISCHE PATENTSCHRIFT

(11) **EP 3 146 813 B1**
(45) Veröffentlichungstag und Bekanntmachung des Hinweises auf die Patenterteilung: **04.11.2020**
(21) Anmeldenummer: 15710771.5
(22) Anmeldetag: 18.03.2015
(51) Int. Cl.: H05K 5/00

(54) **ELEKTRONISCHES STEUERMODUL, INSBESONDERE FÜR GETRIEBESTEUERUNG, MIT AN PRESSKONTAKTE ANGESCHWEISSTEN ELEKTRISCHEN BAUTEILEN**
ELECTRONIC CONTROL MODULE, IN PARTICULAR FOR GEAR MECHANISM CONTROL, WITH ELECTRICAL COMPONENTS WHICH ARE WELDED TO PRESS CONTACTS
MODULE DE COMMANDE ÉLECTRONIQUE, EN PARTICULIER DESTINÉ À UNE COMMANDE DE BOÎTE DE VITESSES, ÉQUIPÉ DE COMPOSANTS ÉLECTRIQUES SOUDÉS À DES CONTACTS INSÉRÉS À FORCE

(30) Priorität: 19.05.2014 DE 102014209411
(43) Veröffentlichungstag der Anmeldung: 29.03.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2015/055608
(87) Internationale Veröffentlichungsnummer: WO 2015/176842

(56) Entgegenhaltungen:
- DE-A1-102011 083 576
- DE-A1-102011 085 170
- DE-A1-102011 086 896
- DE-A1-102011 089 474
- US-A1- 2005 239 343

## Beschreibung

### Stand der Technik

Die Erfindung betrifft ein elektronisches Steuermodul, wie es insbesondere für Getriebesteuerungen in Kraftfahrzeugen eingesetzt werden kann, sowie ein Verfahren zum Fertigen eines elektronischen Steuermoduls.

Bei Kraftfahrzeugen werden elektronische Steuermodule insbesondere zur Ansteuerung von Getrieben eingesetzt. Dabei kann es vorteilhaft sein, ein Steuermodul am Getriebe, beispielsweise innerhalb eines Getriebegehäuses, derart anzuordnen, dass es mit dem Getriebefluid wie beispielsweise einem aggressiven Getriebeöl in Kontakt kommt.

Die Steuermodule können beispielsweise elektrische Bauteile wie Stecker, Sensoren, Aktuatoren, wenigstens ein gekapseltes Steuergerät (TCU, Transmission Control Unit) und gegebenenfalls weitere Komponenten aufweisen. Die elektrischen Bauteile können an einer Leiterplatte angeordnet sein. Die Leiterplatte kann eine herkömmliche Platine sein, an deren Oberfläche oder in deren Innerem Leiterbahnen ausgebildet sind, mithilfe derer die an einer Bestückungsseite der Leiterplatte angeordneten elektrischen Bauteile miteinander elektrisch verbunden werden könnten. Jedes der elektrischen Bauteile kann hierzu elektrisch leitfähige Anschlussabschnitte aufweisen, beispielsweise in Form von aus dem Bauteil herausgeführten Drähten, mittels derer das Bauteil mit einer der an der Leiterplatte vorgesehenen Leiterbahnen in elektrischen Kontakt gebracht werden kann.

Eine Anordnung des Steuermoduls im Getriebefluid kann hohe Herausforderungen an die Aufbau- und Verbindungstechnik der Baukomponenten auf der Leiterplatte des elektronischen Steuermoduls stellen, da die elektrischen Verbindungen z.B. hohen Temperaturwechselbelastungen ausgesetzt sind und ferner dem aggressiven Getriebefluid und gegebenenfalls darin enthaltenen Metallspänen widerstehen können müssen.

Herkömmlich wurden die elektrischen Bauteile meist mit ihren Anschlussabschnitten an die Leiterbahnen der Leiterplatte angelötet. Die US 2009/0176402 A1 und die US 2008/0144260 A1 zeigen zum Beispiel Steckerteile, deren Anschlusselemente in Durchkontaktierungen der Leiterplatte eingelötet sind.

Es wurde jedoch beobachtet, dass Lötverbindungen nicht immer eine z.B. im Fahrzeugbau erforderliche Zuverlässigkeit langfristig gewährleisten können und es daher zu Fehlfunktionen oder Ausfällen bei elektronischen Steuermodulen für Getriebesteuerungen kommen kann.

DE 10 2011 083 576 A1 zeigt eine Vorrichtung zur Außenkontaktierung eines Schaltungsmoduls.

### Offenbarung der Erfindung

Ausführungsformen der vorliegenden Erfindung ermöglichen ein elektronisches Steuermodul, das insbesondere den bei einer Verwendung als Getriebesteuerung auftretenden hohen Anforderungen hinsichtlich einer langfristig stabilen elektrischen Verbindung zwischen elektrischen Bauteilen und Leiterbahnen einer Leiterplatte besser gerecht werden kann als herkömmliche Steuermodule. Insbesondere können Ausführungsformen erfindungsgemäßer Steuermodule einfach, zuverlässig und/oder kostengünstig hergestellt werden.

Gemäß einem ersten Aspekt der Erfindung wird ein elektronisches Steuermodul, insbesondere für eine Getriebesteuerung, vorgeschlagen, welches eine Leiterplatte sowie wenigstens ein elektrisches Bauteil aufweist. Die Leiterplatte ist mit Leiterbahnen versehen und besitzt eine Bestückungsseite. Das elektrische Bauteil weist mindestens einen elektrisch leitfähigen Anschlussabschnitt auf. Das Steuermodul weist wenigstens einen Presskontakt auf, der in eine Öffnung in der Leiterplatte derart eingepresst ist, dass er mechanisch an der Leiterplatte fixiert ist und über einen in die Leiterplatte eingepressten Teilbereich eines elektrisch leitfähigen Gegenanschlussabschnitts des Presskontakts sowohl einen mechanischen als auch einen elektrischen Kontakt mit einer Leiterbahn der Leiterplatte bildet. Ferner ist eine Schweißverbindung zwischen dem Anschlussabschnitt des elektrischen Bauteils und dem Gegenanschlussabschnitt des Presskontakts vorgesehen. Der Presskontakt ist im Wesentlichen rechtwinklig ausgeführt ist, so dass ein unterer Schenkel senkrecht zur Ebene der Leiterplatte in deren Öffnung eingeführt werden kann und ein oberer Schenkel rechtwinklig zu dem unteren Schenkel angeordnet ist und somit im Wesentlichen parallel zu der Bestückungsseite der Leiterplatte verläuft. Erfindungsgemäß ist der Presskontakt derart ausgestaltet, dass er in einen in die Leiterplatte eingepressten Zustand mit einem oberen Schenkel an der Bestückungsseite anliegt.

Gemäß einem zweiten Aspekt der Erfindung wird ein Verfahren zum Fertigen eines elektronischen Steuermoduls, insbesondere eines Steuermoduls gemäß dem obigen ersten Aspekt der Erfindung, beschrieben. Bei dem Verfahren werden eine Leiterplatte mit einer Bestückungsseite und mit Leiterbahnen sowie ein elektrisches Bauteil mit wenigstens einem elektrisch leitfähigen Anschlussabschnitt bereitgestellt. Der Presskontakt wird in eine Öffnung in der Leiterbahn derart eingepresst, dass er mechanisch an der Leiterplatte fixiert ist und über einen in die Leiterplatte eingepressten Teilbereich eines elektrisch leitfähigen Gegenanschlussabschnitts des Presskontakts sowohl einen mechanischen als auch einen elektrischen Kontakt mit einer Leiterbahn der Leiterplatte bildet und der Anschlussabschnitt des elektrischen Bauteils mit dem Gegenanschlussabschnitt des Presskontakts verschweißt wird. Der Presskontakt ist im Wesentlichen rechtwinklig ausgeführt ist, so dass ein unterer Schenkel senkrecht zur Ebene der Leiterplatte in deren Öffnung eingeführt werden kann und ein oberer Schenkel rechtwinklig zu dem unteren Schenkel angeordnet ist und somit im Wesentlichen parallel zu der Bestückungsseite der Leiterplatte verläuft. Erfindungsgemäß ist der Presskontakt derart ausgestaltet, dass er in einen in die Leiterplatte eingepressten Zustand mit einem oberen Schenkel an der Bestückungsseite anliegt.

Ausführungsformen der Erfindung können unter anderem als auf den nachfolgend beschriebenen Ideen und Gedanken basierend angesehen werden:
Wie einleitend ausgeführt, wurden bei herkömmlichen elektronischen Steuermodulen elektrische Bauteile im Allgemeinen mit Leiterbahnen einer Leiterplatte verlötet. Hierzu wurden beispielsweise Anschlussabschnitte eines elektrischen Bauteils in Durchgangsöffnungen in der Leiterplatte angeordnet und dann von einer gegenüberliegenden Seite her in ein Lötbad eingetaucht, so dass Lot die Anschlussabschnitte mit den Leiterbahnen elektrisch leitfähig verbinden konnte.

Allerdings wurde beobachtet, dass derart hergestellte Lötverbindungen eine gewisse Ausfallwahrscheinlichkeit aufweisen können, beispielsweise im Bereich von 2 ppm, und es dadurch zu Fehlern im Betrieb des Elektronikmoduls kommen kann. Diese Problematik hat sich in den letzten Jahren teilweise verschärft, da nach neueren Richtlinien im Allgemeinen kein bleihaltiges Lot mehr verwendet werden darf. Deshalb müssen Lötverbindungen aufwendig entwickelt und erprobt werden und an thermomechanische Besonderheiten von bleifreiem Lot angepasst werden.

Es wird daher vorgeschlagen, herkömmliche Lötverbindungen bei einem elektronischen Steuermodul durch eine neue Art der elektrischen Anbindung von elektrischen Bauteilen an eine Leiterplatte zu ersetzen, bei der auf Lot verzichtet werden kann. Bei dieser Anbindung wird zunächst ein bzw. mehrere Presskontakte in eine Öffnung in der Leiterplatte eingepresst.

Unter einem Presskontakt kann hierbei ein kleines Bauelement verstanden werden, das vollständig aus elektrisch leitfähigem Material, beispielsweise einem Metall, besteht oder zumindest teilweise, beispielsweise an seiner Oberfläche, mit einem elektrisch leitfähigen Material versehen ist. Der Presskontakt weist dabei zumindest einen Steg auf, der derart dimensioniert ist, dass er unter Druck in eine in der Leiterplatte vorgesehene Öffnung eingepresst werden kann. Die Struktur bzw. Abmessungen des Steges sind dabei derart ausgelegt, dass zumindest an einem in die Leiterplatte eingepressten Teilbereich des elektrisch leitfähigen Gegenanschlussabschnitts des Presskontakts leitfähiges Material des Presskontakts an leitfähiges Material einer Leiterbahn der Leiterplatte im Bereich der Öffnung gepresst wird und somit eine elektrische Verbindung hergestellt wird. Ferner ist der Steg des Presskontakts derart bemessen, dass der Presskontakt nach dem Einpressen in die Öffnung mechanisch stabil an der Leiterplatte gehalten ist. Da das Einpressen des Presskontaktes im Allgemeinen keine lokale Erwärmung von zu verbindenden Komponenten erfordert, wird hierbei auch von Kaltkontaktierung gesprochen.

Zusätzlich zu dem in die Öffnung eingepressten Steg weist der Presskontakt einen elektrisch leitfähigen Gegenanschlussabschnitt auf. Dieser Gegenanschlussabschnitt ist elektrisch leitfähig mit dem elektrisch leitfähigen Material an dem Steg des Presskontakts verbunden, so dass nach dem Einpressen insgesamt eine elektrische Verbindung zwischen dem Gegenanschlussabschnitt und der Leiterbahn der Leiterplatte gegeben ist.

Nachdem der Presskontakt bzw. die Presskontakte an der Leiterplatte angeordnet wurden, können die elektrischen Bauteile an der Bestückungsseite der Leiterplatte angeordnet werden und dann deren Anschlussabschnitte mit den Gegenanschlussabschnitten der Presskontakte geeignet verschweißt werden.

Bei dem beschriebenen Fertigungsverfahren bzw. dem entsprechend gefertigten elektronischen Steuermodul kann ein Verlöten von elektrischen Bauteilen entfallen und durch das Einpressen von Presskontakten und anschließendes Verschweißen der Anschluss- und Gegenanschlussabschnitte ersetzt werden. Hierdurch können im Vergleich zu dem herkömmlichen Verlöten Erprobungs- und Entwicklungskosten signifikant reduziert werden. Beispielsweise müssen Lötstellen im Allgemeinen vier Mal länger erprobt werden als Schweißstellen. Außerdem kann davon ausgegangen werden, dass eine Ausfallstatistik bei Schweißverbindungen deutlich geringer ist als bei Lötverbindungen. Insbesondere wird davon ausgegangen, dass Schweißverbindungen praktisch keine Fehler im Betrieb aufweisen, wohingegen bei Lötverbindungen eine Ausfallstatistik von 2 ppm beobachtet werden kann. Ergänzend haben Schweißverbindungen im Vergleich zu Lötverbindungen eine deutlich höhere mechanische Belastbarkeit und Temperaturfestigkeit.

Wie weiter unten detaillierter beschrieben, können bei dem vorgeschlagenen Fertigungsverfahren ferner thermisch bedingte mechanische Verspannungen innerhalb des elektronischen Steuermoduls erheblich reduziert werden, da es z.B. bei dem lokalen, schnellen Verschweißen der Anschluss- und Gegenanschlussabschnitte zu einem wesentlich geringeren Wärmeeintrag kommt als bei herkömmlichen Lötvorgängen.

Gemäß einer Ausführungsform können der Anschlussabschnitt des elektronischen Bauteils und der Gegenanschlussabschnitt des Presskontakts mit Kupfer ausgebildet sein, d.h. aus einem kupferhaltigen Material oder vollständig aus Kupfer bestehen. Kupfer hat nicht nur eine ausgezeichnete elektrische Leitfähigkeit, sondern auch einen verhältnismäßig geringen Schmelzpunkt, so dass es bereits bei geringen Wärmeleistungen verschweißt werden kann.

Insbesondere kann es vorteilhaft sein, den Anschlussabschnitt des elektrischen Bauteils mit dem Gegenanschlussabschnitt des Presskontakts mittels eines Lasers zu verschweißen. Laserschweißen ist industriell gut einsetzbar und kann viele Vorteile bieten wie zum Beispiel eine hohe Positionierungsgenauigkeit der Verschweißung, berührungsloses und damit kontaminationsfreies Verschweißen, Energieeffizienz, etc.

Insbesondere kann zum Laserverschweißen von z.B. in dem Anschlussabschnitt und dem Gegenanschlussabschnitt enthaltenem Kupfer grünes Laserlicht eingesetzt werden. Zum Kupfer-Kupfer-Verschweißen können wesentlich kleinere und kostengünstigere Anlagen eingesetzt werden, als dies bei beispielsweise für andere Zwecke herkömmlich häufig verwendetem NiFe-Cu-Laserschweißen bekannt ist. Ein zum Cu-Cu-Verschweißen einsetzbarer Laser kann beispielsweise wesentlich geringere Laserleistungen aufweisen, als dies bei herkömmlichen zum Verschweißen eingesetzten Lasern der Fall ist.

Beispielsweise kann der Laser eine Laserlichtleistung im kontinuierlichen Betriebsmodus von weniger als 500 W, vorzugsweise weniger als 200 W, aufweisen. Zum Cu-Cu-Verschweißen können beispielsweise Scheibenlaser eingesetzt werden, die im kontinuierlichen Betriebsmodus Laserlicht im grünen Wellenlängenbereich emittieren und eine maximale Laserleistung von 200 W haben und dabei aufgrund einer Beugungsmaßzahl von konstant weniger als 1,15 eine sehr hohe Strahlqualität aufweisen können. Um eine Emissionswellenlänge von beispielsweise 515 nm erzielen zu können, wird dabei innerhalb eines Laserresonators eine Frequenzverdopplung der Scheibenlaserstrahlung durchgeführt. Das derart erzeugte grüne Laserlicht wird von Kupferwerkstoffen deutlich besser absorbiert als Laserstrahlung im infraroten Wellenlängenbereich. Es wurde ferner beobachtet, dass beim Laserverschweißen mit grünem, verhältnismäßig leistungsarmem Laserlicht im Wesentlichen keine Schweißspritzer auftreten, wodurch der Schweißvorgang erheblich vereinfacht werden kann.

Gemäß einer Ausführungsform der Erfindung kann der Anschlussabschnitt des elektrischen Bauteils und der Gegenanschlussabschnitt des Presskontakts parallel zu der Bestückungsseite der Leiterplatte angeordnet sein. Hierdurch kann erreicht werden, dass die beiden Abschnitte einfach erreichbar sind und von oben her mittels eines Lasers miteinander verschweißt werden können.

Gemäß einer Ausführungsform der Erfindung kann die Schweißverbindung zwischen dem Anschlussabschnitt des elektrischen Bauteils und dem Gegenanschlussabschnitt des Presskontakts mit einem elektrisch isolierenden Material abgedeckt sein. Beispielsweise kann der gesamte freiliegende Bereich der beiden Anschluss- und Gegenanschlussabschnitte mit elektrisch isolierendem Material abgedeckt sein und somit gegen Schmutz, Feuchtigkeit oder Korrosion geschützt sein. Das elektrisch isolierende Material kann beispielsweise in Form eines Lacks oder einer Vergussmasse wie zum Beispiel Globe-Top oder Epoxi vorgesehen sein.

Gemäß einer Ausführungsform der Erfindung kann das elektronische Steuermodul ferner eine Trägerplatte aufweisen, welche an die Leiterplatte an einer Oberfläche entgegensetzt der Bestückungsseite angeordnet ist, wobei die Trägerplatte aus Kunststoff besteht. Bei herkömmlichen Steuermodulen wurde an einer Leiterplatte meist eine Trägerplatte aus Metall vorgesehen. Eine reine Kunststoffträgerplatte würde beim herkömmlichen Löten z.B. insbesondere in der Vorwärmstrecke thermisch stark beschädigt werden, weshalb herkömmlich Metallplatten als Trägerplatten eingesetzt werden. Bei dem hier vorgeschlagenen Konzept wird kaltkontaktiert, weshalb auch Trägerplatten aus Kunststoff eingesetzt werden können. Außerdem kann eine Kunststoffträgerplatte auch unten geschlossen sein und damit einen Isolationsschutz bezüglich eventuell nach unten rausragender Pins bieten. Unter einer Elektronik wird lokal meist eine Metalleinlage benötigt, um als Kühlfläche Verlustwärme ins Getriebe abzuleiten zu können.

Die Trägerplatte kann angrenzend an einen über die Trägerplatte hinausragenden Bereich eines Presskontakts ein diesen Bereich aufnehmendes Sackloch aufweisen. Mit anderen Worten kann die Trägerplatte an die Oberfläche der Leiterplatte entgegengesetzt der Bestückungsseite angelagert werden und, da an dieser Oberfläche im Bereich der Durchgangslöcher in der Leiterplatte Teile der darin eingefügten Presskontakte überstehen können, entsprechend dimensionierte Ausnehmungen aufweisen. Diese Ausnehmungen können als Sacklöcher ausgebildet sein, das heißt, nicht durchgängig sondern einseitig verschlossen sein, so dass die überstehenden Bereiche der Presskontakte in der Ausnehmung der Trägerplatte aufgenommen werden können und nach außen hin vor Schmutz und Korrosion geschützt sind.

Durch eine Verwendung einer Trägerplatte aus Kunststoff statt aus Metall kann eine erhebliche Gewichtsreduzierung für das Steuermodul erreicht werden. Außerdem kann ein Spanschutzdeckel an der Unterseite des Steuermoduls entfallen. Ein Spanschutzdeckel an der Oberseite der Leiterplatte kann wie oben beschrieben durch Vorsehen eines elektrisch isolierenden Materials, beispielsweise in Form eines Lacks oder einer Vergussmasse, ersetzt werden.

Insgesamt kann durch das vorgeschlagene Fertigungsverfahren bzw. bei dem entsprechend gefertigten elektronischen Steuermodul ein Moldgehäuse sowie eine Befestigungsfeder der Elektronik entfallen.

Außerdem kommt es zu keinen ausgeprägten thermischen Spannungen in dem Modul, da alle Bauteile mit der Leiterplatte verbunden sind und die Trägerplatte nur eine elektrische Isolation und ein Transportschutz ist, sofern daran keine weiteren Anforderungen, wie zum Beispiel Funktionen in Form eines integrierten Steckers, gestellt werden.

Es wird darauf hingewiesen, dass mögliche Merkmale und Vorteile von Ausführungsformen der Erfindung hierin teilweise mit Bezug auf ein elektronisches Steuermodul und teilweise mit Bezug auf ein Verfahren zum Fertigen eines elektronischen Steuermoduls beschrieben sind. Ein Fachmann erkennt, dass die Merkmale geeignet miteinander kombiniert, angepasst bzw. ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Beschreibung noch die Zeichnungen als die Erfindung einschränkend auszulegen sind.
Fig. 1 zeigt einen Querschnitt durch ein herkömmliches Getriebesteuermodul.
Fig. 2 zeigt einen Querschnitt durch ein Steuermodul für eine Getriebesteuerung gemäß einer Ausführungsform der vorliegenden Erfindung.
Fig. 3 zeigt eine vergrößerte Querschnittsansicht einer elektrischen Anbindung eines elektrischen Bauteils an eine Leiterplatte eines Steuermoduls gemäß einer Ausführungsform der vorliegenden Erfindung.

Die Figuren sind lediglich schematisch und nicht maßstabsgetreu. Gleiche Bezugszeichen bezeichnen in den Figuren gleiche bzw. gleich wirkende Merkmale.

### Ausführungsformen der Erfindung

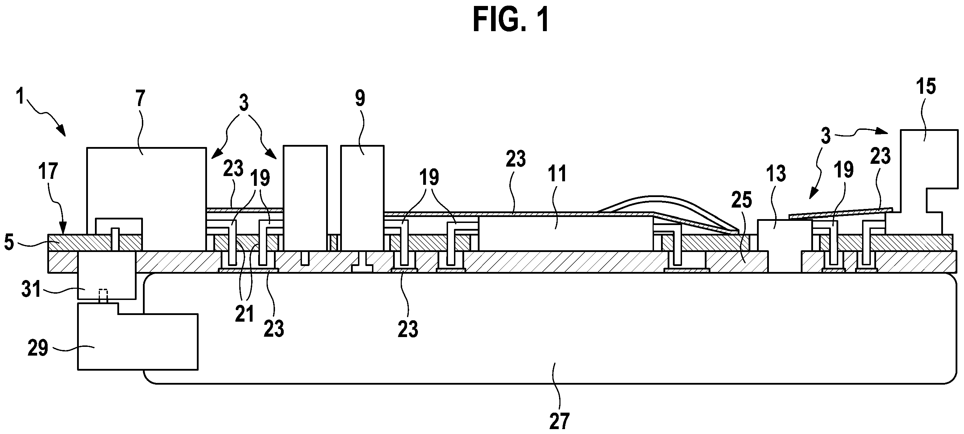

Fig. 1 zeigt ein herkömmliches Getriebesteuermodul 1, bei dem mehrere elektrische Bauteile 3 mit einer Leiterplatte 5 verlötet sind.

Die Leiterplatte 5, welche teilweise auch als Platine oder PCB (Printed Circuit Board) bezeichnet wird, weist an ihrer Oberfläche oder in ihr Inneres integriert mehrere Leiterbahnen auf (in Figur 1 nicht separat dargestellt). Die elektrischen Bauteile 3 können beispielsweise als Hochstrombaugruppe 7, Drehzahl-, Positions- oder Wegsensoren 9, Elektronikschaltungen 11, Drucksensoren 13 und/oder Stecker 15 an einer Bestückungsseite 17 der Leiterplatte 5 angeordnet sein. Jedes der Bauteile 3 ist über zugehörige elektrisch leitfähige Anschlussabschnitte 19 mit Leiterbahnen der Leiterplatte 5 elektrisch verbunden, so dass die einzelnen Bauteile 3 untereinander über die Leiterbahnen elektrisch verbunden sein können. Hierzu werden die Anschlussabschnitte 19 durch Durchgangslöcher 21 in der Leiterplatte 5 hindurchgesteckt und beispielsweise von unten her durch Eintauchen in ein Lötbad mit den Leiterbahnen der Leiterplatte 5 verlötet.

Um die Anschlussabschnitte 19 beispielsweise gegen Metallspäne, wie sie in umgebendem Getriebeöl enthalten sein können, zu schützen, sind Spanschutzdeckel 23 vorgesehen. Gegenüber der Bestückungsseite 17 ist an der Leiterplatte 5 eine Trägerplatte 25 aus Metall vorgesehen. Diese Trägerplatte 25 kann einerseits die Leiterplatte 5 stabilisieren und andererseits für einen guten Wärmetransfer von den elektrischen Bauteilen hin zu einem Getriebebauteil 27 wie beispielsweise einer Hydraulikplatte, an dem das Getriebesteuermodul 1 befestigt ist, sorgen. An der Unterseite der Leiterplatte 5 ist ferner ein Druckregler 29 mit einem Stecker vorgesehen, der über einen Kontaktblock bzw. Gegenstecker 31 mit der Leiterplatte 5 verbunden ist.

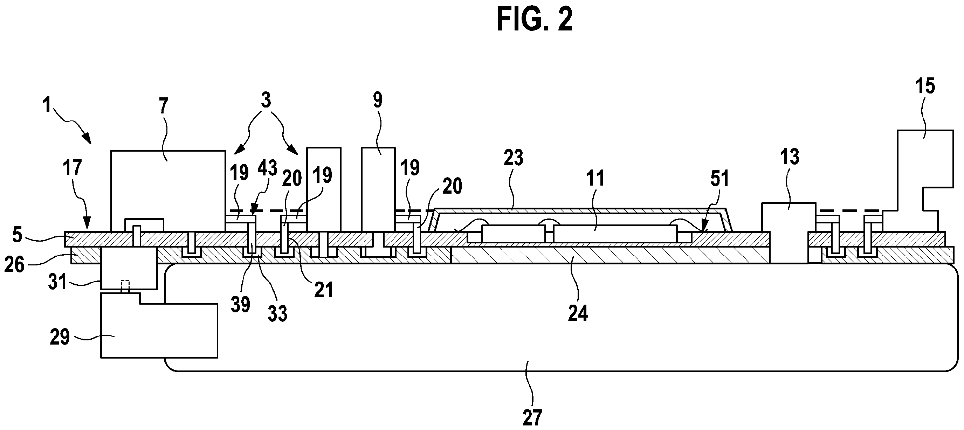

Fig. 2 zeigt ein elektronisches Steuermodul 1 gemäß einer Ausführungsform der vorliegenden Erfindung.

Wie bei einem herkömmlichen Getriebesteuermodul 1 sind verschiedene elektrische Bauteile 3 in Form unterschiedlicher Komponenten 7, 9, 11, 13, 15 an der Bestückungsseite 17 einer Leiterplatte 5 angeordnet. Allerdings sind Anschlussabschnitte 19 dieser Bauteile 3 nicht mit Leiterbahnen der Leiterplatte 5 verlötet. Stattdessen sind in Öffnungen 21 der Leiterplatte Presskontakte 39 eingepresst, so dass sie einerseits mechanisch fest verankert sind und andererseits einen elektrischen Kontakt zu den Leiterbahnen der Leiterplatte 5 bilden. An einen Gegenanschlussabschnitt 20 eines Presskontakts 39 ist der Anschlussabschnitt 19 des elektrischen Bauteils 3 lokal angeschweißt.

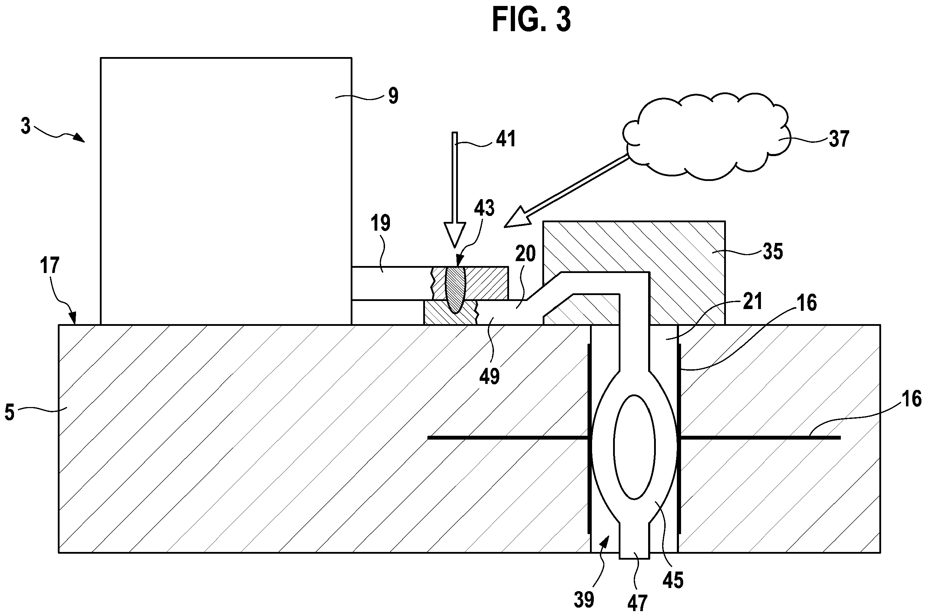

In Fig. 3 ist die Anordnung und elektrische Verbindung des Bauteils 3 mit der Leiterplatte 5 vergrößert dargestellt. Der Presskontakt 39 ist derart ausgestaltet und dimensioniert, dass er unter Druck in eine der Öffnungen 21 in der Leiterplatte 5 eingepresst werden kann. Dabei kann der Presskontakt 39 mit einem verdickten Bereich 45 in der Leiterplatte 5 derart gehalten sein, dass sowohl eine mechanisch stabile Fixierung gegeben ist als auch eine elektrische Kontaktierung zwischen dem Gegenanschlussabschnitt 20 des Presskontakts 39 einerseits und in der Leiterplatte 5 vorgesehenen Leiterbahnen 16 andererseits ausgebildet wird. Die Leiterbahnen 16 können dabei im Innern der Leiterplatte 5 verlaufen und einen Teilbereich des Gegenanschlussabschnitts 20 im Innern der Öffnung 20 kontaktieren. Beispielsweise kann das Innere der Öffnung mit einer Metallschicht versehen sein.

Der Presskontakt 39 kann beispielsweise vollständig aus Metall bestehen, insbesondere beispielsweise vollständig aus Kupfer oder einer Kupferlegierung bestehen. Gegebenenfalls kann er mit einer Oberflächenbeschichtung z.B. aus Gold, Zinn versehen sein. Der Presskontakt kann einstückig sein. Der Presskontakt kann ferner im Wesentlichen rechtwinklig ausgeführt sein, so dass ein unterer Schenkel 47 senkrecht zur Ebene der Leiterplatte 5 in deren Öffnung 21 eingeführt werden kann und ein oberer Schenkel 49 rechtwinklig zu dem unteren Schenkel 47 angeordnet ist und somit im Wesentlichen parallel zu der Bestückungsseite 17 der Leiterplatte 5 verlaufen kann. Der Presskontakt 39 kann dabei derart ausgestaltet sein, dass er im in die Leiterplatte 5 eingepressten Zustand mit seinem oberen Schenkel 49 an der Bestückungsseite 17 anliegt.

Ein ebenfalls an dem Presskontakt 39 vorgesehener Kunststoffrahmen 35 kann Teilbereiche des Presskontakts 39 sowie die Öffnung 21 vor Verschmutzung insbesondere durch Metallspäne schützen.

Das an der Bestückungsseite 17 angeordnete elektrische Bauteil 3, beispielsweise in Form eines Sensors 9, verfügt über einen Anschlussabschnitt 19, der zumindest teilweise überlappend mit dem Gegenanschlussabschnitt 20 des Presskontakts 39 angeordnet ist. Beide Abschnitte 19, 20 verlaufen somit parallel zur Bestückungsseite 17 und können somit einfach mit einem von oben senkrecht zu der Bestückungsseite 17 eingestrahlten Laser, veranschaulicht durch den Pfeil 41, miteinander über eine Verschweißung 43 verbunden werden.

Im Bereich der Verschweißung 43 und den angrenzenden Teilbereichen der Anschluss- und Gegenanschlussabschnitte 19, 20 kann eine nachträglich aufgebrachte Schicht aus elektrisch isolierendem Material 37, beispielsweise einem Globe-Top, für Schutz gegen Verunreinigungen sorgen.

Wie in Fig. 2 dargestellt, kann die Leiterplatte 5 über eine Trägerplatte 26 aus Kunststoff mit dem Getriebebauteil 27 verbunden sein. In der Trägerplatte 26 kann beispielsweise im Bereich einer Elektronikschaltung 11, welche im Betrieb viel Wärme erzeugt, lokal eine Metallplatte 24 integriert sein, um Wärme besser an das Getriebebauteil 27 ableiten zu können.

Angrenzend an Bereiche der Presskontakte 39, die über die Leiterplatte 5 nach unten hinausragen, kann in der Trägerplatte 26 jeweils ein ausreichend groß dimensioniertes Sackloch 33 ausgebildet sein, so dass die über die Leiterplatte 5 hinausragenden Bereiche des Presskontakts 39 einerseits darin aufgenommen werden können und andererseits, da das Sackloch 33 nach unten hin verschlossen ist, beispielsweise gegen Verschmutzung geschützt sind.

Abschließend soll ein Montageablauf im Rahmen einer Fertigung eines elektronischen Steuermoduls beschrieben werden.

Zunächst werden die Presskontakte 39 in die Öffnungen 21 der Leiterplatte 5 gefügt. Bondflächen 51 werden gegebenenfalls gereinigt. Die Elektronikschaltung 11 wird eingeklebt und gebondet und mit einem dichten Deckel 23 beispielsweise mittels eines Klebstoffs oder eines Dichtrings verschlossen. Anschließend wird die Leiterplatte 5 mit allen restlichen Bauteilen 3 bestückt. Baugruppen wie beispielsweise Sensoren 9 und Stecker 15 werden aufgeklebt oder in die Leiterplatte 5 über Bohrungen eingerastet oder angenietet. Nachfolgend wird die Kunststoffträgerplatte 26, gegebenenfalls mit einer eingelegten oder umspritzten Metallplatte 24 zur Entwärmung der Elektronikschaltung 11, vorbereitet. Die bestückte Leiterplatte 5 kann jetzt oder zu einem späteren Zeitpunkt auf die Trägerplatte 26 gelegt und an wenigen Stellen beispielsweise durch Kleben, Nieten oder Rasten befestigt werden.

Die elektrischen Bauteile 3 wie beispielsweise die Sensoren 9, 13, usw. haben Anschlussabschnitte 19, die nach der Montage mit leichter vertikaler Vorspannung an Schweißflächen an den Gegenanschlussabschnitten 20 der Presskontakte 39 anliegen. Alle Einzelteile können sich bis dahin bezüglich ihrer Positionen ausgleichen. Verspannungen und Verzüge während der Montage wirken sich im Wesentlichen nicht auf die elektrische Verbindung der Bauteile 3 mit der Leiterplatte 5 aus. Jetzt erst erfolgt das Verschweißen der Anschlussabschnitte 19 mit den Gegenanschlussabschnitten 20, nahezu ohne thermischen Verzug, wegen geringer Schmelztemperaturen der beispielsweise aus Kupfer bestehenden Presskontakte 39, und minimalem Wärmeeintrag auf sehr kleiner Fläche (Schweißpunkt). Als Laserstrahl 41 wird grünes Laserlicht verwendet, das speziell für Kupfer-Kupfer-Schweißungen entwickelt wurde. Anschließend kann die im Bereich der Anschluss- und Gegenanschlussabschnitte 19, 20 gebildete elektrische Verbindung mit Deckeln oder Lack oder Vergussmasse aus elektrisch isolierendem Material, wie zum Beispiel Globe-Top, abgedeckt werden.

Presskontakte sind kostengünstiger und zuverlässiger als beispielsweise THT-Lötstellen (Through-Hole-Technique). Globe-Top kann auch die Presskontaktierung in einer Leiterplattenöffnung 21 vor korrosivem Angriff des umgebenden Mediums, beispielsweise aggressivem Getriebeöl, schützen. Die gesamte Bestückung der Leiterplatte 5 kann mittels einer vollautomatisierten Montage auf einer sehr kompakten Anlage erfolgen. Es sind keine großen Selektiv- oder Durchlaufofen-Lötanlagen und auch keine Vorwärm- oder Abkühlstrecken notwendig. Die Presskontakte 39 können geregelt eingepresst und laserverschweißt werden. Dadurch können Prüfvorgänge, wie zum Beispiel das beim Löten übliche Röntgen, entfallen.

Die in den oben beschriebenen Ausführungsformen enthaltene eingelegte Metallplatte 24, welche als Wärmeleitplatte dienen kann, kann entfallen, wenn die Leiterplatte 5 zum Beispiel im Bereich der Elektronik mit Kühlöl angeströmt wird oder eine plateauartige Erhebung der als Getriebebauteil 27 wirkenden Hydraulikplatte durch die Trägerplatte 26 hindurch die Leiterplatte 5 direkt berührt. Die Leiterplatte 5 kann ferner über thermische Vias unterhalb der Elektronik verfügen, um eine bessere Entwärmung bewirken zu können.

## Patentansprüche

1. Elektronisches Steuermodul (1), insbesondere für eine Getriebesteuerung, aufweisend:
eine Leiterplatte (5) mit einer Bestückungsseite (17) und mit Leiterbahnen (16);
wenigstens ein elektrisches Bauteil (3) mit wenigstens einem elektrisch leitfähigen Anschlussabschnitt (19);
wenigstens einen Presskontakt (39), der in eine Öffnung (21) in der Leiterplatte (5) derart eingepresst ist, dass er mechanisch an der Leiterplatte (5) fixiert ist und über einen in die Leiterplatte eingepressten Teilbereich eines elektrisch leitfähigen Gegenanschlussabschnitts (20) des Presskontakts (39) sowohl einen mechanischen als auch einen elektrischen Kontakt mit einer Leiterbahn (16) der Leiterplatte (5) bildet;
eine Schweißverbindung (43) zwischen dem Anschlussabschnitt (19) des elektrischen Bauteils (3) und dem Gegenanschlussabschnitt (20) des Presskontakts (39), wobei der Presskontakt (39) im Wesentlichen rechtwinklig ausgeführt ist, so dass ein unterer Schenkel (47) senkrecht zur Ebene der Leiterplatte (5) in deren Öffnung (21) eingeführt werden kann und ein oberer Schenkel (49) rechtwinklig zu dem unteren Schenkel (47) angeordnet ist und somit im Wesentlichen parallel zu der Bestückungsseite (17) der Leiterplatte (5) verläuft,
**dadurch gekennzeichnet, dass** der Presskontakt (39) derart ausgestaltet ist, dass er in einem in die Leiterplatte (5) eingepressten Zustand mit einem oberen Schenkel (49) an der Bestückungsseite (17) anliegt.

2. Elektronisches Steuermodul nach Anspruch 1, wobei der Anschlussabschnitt (19) des elektrischen Bauteils (3) und der Gegenanschlussabschnitt (20) des Presskontakts (39) mit Kupfer ausgebildet sind.

3. Elektronisches Steuermodul nach Anspruch 1 oder 2, wobei der Anschlussabschnitt (19) des elektrischen Bauteils (3) und zumindest ein Teilbereich des Gegenanschlussabschnitts (20) des Presskontakts (39) parallel zu der Bestückungsseite (17) der Leiterplatte (5) angeordnet sind.

4. Elektronisches Steuermodul nach einem der Ansprüche 1 bis 3, wobei die Schweißverbindung (43) zwischen dem Anschlussabschnitt (19) des elektrischen Bauteils (3) und dem Gegenanschlussabschnitt (20) des Presskontakts (39) mit elektrisch isolierendem Material (37) abgedeckt ist.

5. Elektronisches Steuermodul nach einem der Ansprüche 1 bis 4, ferner aufweisend eine Trägerplatte (26) aus Kunststoff, welche an die Leiterplatte (5) an einer Oberfläche entgegengesetzt der Bestückungsseite (17) angeordnet ist.

6. Elektronisches Steuermodul nach Anspruch 5, wobei die Trägerplatte (26) angrenzend an einen über die Leiterplatte (5) hinausragenden Bereich eines Presskontakts (39) ein diesen Bereich aufnehmendes Sackloch (33) aufweist.

7. Elektronisches Steuermodul nach einem der Ansprüche 1 bis 6, wobei die Leiterbahn (16) der Leiterplatte (5) in einem innenliegenden Bereich der Öffnung (21) an den Presskontakt (39) angrenzt und den elektrischen Kontakt zu dem Gegenanschlussabschnitt (20) des Presskontakts (39) bildet.

8. Verfahren zum Fertigen eines elektronischen Steuermoduls (1), insbesondere für eine Getriebesteuerung, aufweisend:
Bereitstellen einer Leiterplatte (5) mit einer Bestückungsseite (17) und mit Leiterbahnen (16);
Bereitstellen wenigstens eines elektrischen Bauteils (3) mit wenigstens einem elektrisch leitfähigen Anschlussabschnitt (19);
wobei das Verfahren ferner aufweist:
Einpressen eines Presskontakts (39) in eine Öffnung (21) in der Leiterplatte (5) derart, dass er mechanisch an der Leiterplatte (5) fixiert ist und über einen in die Leiterplatte eingepressten Teilbereich eines elektrisch leitfähigen Gegenanschlussabschnitts (20) des Presskontakts (39) sowohl einen mechanischen als auch einen elektrischen Kontakt mit einer Leiterbahn (16) der Leiterplatte (5) bildet, wobei der Presskontakt (39) im Wesentlichen rechtwinklig ausgeführt ist, so dass ein unterer Schenkel (47) senkrecht zur Ebene der Leiterplatte (5) in deren Öffnung (21) eingeführt werden kann und ein oberer Schenkel (49) rechtwinklig zu dem unteren Schenkel (47) angeordnet ist und somit im Wesentlichen parallel zu der Bestückungsseite (17) der Leiterplatte (5) verläuft,
Verschweißen des Anschlussabschnitts (19) des elektrischen Bauteils (3) mit dem Gegenanschlussabschnitt (20) des Presskontakts (39),
**dadurch gekennzeichnet, dass** der Presskontakt (39) derart ausgestaltet ist, dass er in einem in die Leiterplatte (5) eingepressten Zustand mit einem oberen Schenkel (49) an der Bestückungsseite (17) anliegt.

9. Verfahren nach Anspruch 8, wobei der Anschlussabschnitt (19) des elektrischen Bauteils (3) mit dem Gegenanschlussabschnitt (20) des Presskontakts (39) mittels eines Lasers (41) verschweißt wird.

10. Verfahren nach Anspruch 9, wobei der Laser (41) zum Verschweißen grünes Laserlicht aussendet.

11. Verfahren nach Anspruch 9 oder 10, wobei der Laser (41) eine Laserlichtleistung im kontinuierlichen Betriebsmodus von weniger als 500W, vorzugsweise weniger als 200W, aufweist.

## Claims

1. Electronic control module (1), in particular for a transmission controller, having:
a printed circuit board (5) having a placement side (17) and having conductor tracks (16);
at least one electrical component (3) having at least one electrically conductive connection section (19) ;
at least one press contact (39) which is pressed into an opening (21) in the printed circuit board (5) in such a manner that it is mechanically fixed to the printed circuit board (5) and forms both a mechanical and an electrical contact to a conductor track (16) of the printed circuit board (5) via a section of an electrically conductive counter-connection section (20) of the press contact (39) that is pressed into the printed circuit board;
a welded connection (43) between the connection section (19) of the electrical component (3) and the counter-connection section (20) of the press contact (39), wherein the press contact (39) is substantially right-angled, with the result that a lower limb (47) can be introduced into the opening (21) of the printed circuit board (5) in a manner perpendicular to the plane of the printed circuit board (5) and an upper limb (49) is arranged at right angles to the lower limb (47) and therefore runs substantially parallel to the placement side (17) of the printed circuit board (5),
**characterized in that** the press contact (39) is configured in such a manner that, in a state pressed into the printed circuit board (5), an upper limb (49) of the press contact rests on the placement side (17).

2. Electronic control module according to Claim 1, wherein the connection section (19) of the electrical component (3) and the counter-connection section (20) of the press contact (39) are formed with copper.

3. Electronic control module according to Claim 1 or 2, wherein the connection section (19) of the electrical component (3) and at least one section of the counter-connection section (20) of the press contact (39) are arranged parallel to the placement side (17) of the printed circuit board (5).

4. Electronic control module according to one of Claims 1 to 3, wherein the welded connection (43) between the connection section (19) of the electrical component (3) and the counter-connection section (20) of the press contact (39) is covered with electrically insulating material (37).

5. Electronic control module according to one of Claims 1 to 4, also having a plastic carrier plate (26) which is arranged on the printed circuit board (5) on a surface opposite the placement side (17).

6. Electronic control module according to Claim 5, wherein the carrier plate (26) has, in a manner adjacent to a region of a press contact (39) projecting beyond the printed circuit board (5), a blind hole (33) which accommodates said region.

7. Electronic control module according to one of Claims 1 to 6, wherein the conductor track (16) of the printed circuit board (5) adjoins the press contact (39) in an inner region of the opening (21) and forms the electrical contact to the counter-connection section (20) of the press contact (39).

8. Method for producing an electronic control module (1), in particular for a transmission controller, comprising:
providing a printed circuit board (5) having a placement side (17) and having conductor tracks (16) ;
providing at least one electrical component (3) having at least one electrically conductive connection section (19);
wherein the method also comprises:
pressing a press contact (39) into an opening (21) in the printed circuit board (5) in such a manner that it is mechanically fixed to the printed circuit board (5) and forms both a mechanical and an electrical contact to a conductor track (16) of the printed circuit board (5) via a section of an electrically conductive counter-connection section (20) of the press contact (39) that is pressed into the printed circuit board, wherein the press contact (39) is substantially right-angled, with the result that a lower limb (47) can be introduced into the opening (21) of the printed circuit board (5) in a manner perpendicular to the plane of the printed circuit board (5) and an upper limb (49) is arranged at right angles to the lower limb (47) and therefore runs substantially parallel to the placement side (17) of the printed circuit board (5),
welding the connection section (19) of the electrical component (3) to the counter-connection section (20) of the press contact (39),
**characterized in that** the press contact (39) is configured in such a manner that, in a state pressed into the printed circuit board (5), an upper limb (49) of the press contact rests on the placement side (17).

9. Method according to Claim 8, wherein the connection section (19) of the electrical component (3) is welded to the counter-connection section (20) of the press contact (39) by means of a laser (41).

10. Method according to Claim 9, wherein the laser (41) emits green laser light for welding.

11. Method according to Claim 9 or 10, wherein the laser (41) has a laser light power in the continuous operating mode of less than 500 W, preferably less than 200 W.

## Revendications

1. Module de commande électronique (1), en particulier pour une commande de boîte de vitesses, présentant :
une carte de circuits imprimés (5) ayant un côté composants (17) et des pistes conductrices (16) ;
au moins un composant électrique (3) ayant au moins une partie de connexion (19) électriquement conductrice ;
au moins un contact par pression (39) qui est pressé dans une ouverture (21) dans la carte de circuits imprimés (5) de telle sorte qu'il est immobilisé mécaniquement au niveau de la carte de circuits imprimés (5) et établit par une zone partielle, enfoncée dans la carte de circuits imprimés, d'une contrepartie de connexion électriquement conductrice (20) du contact par pression (39) un contact à la fois mécanique et électrique avec une piste conductrice (16) de la carte de circuits imprimés (5) ;
un assemblage par soudure (43) entre la partie de connexion (19) du composant électrique (3) et la contrepartie de connexion (20) du contact par pression (39), le contact par pression (39) étant réalisé de manière substantiellement rectangulaire de sorte qu'une branche inférieure (47) peut être introduite perpendiculairement au plan de la carte de circuits imprimés (5) dans l'ouverture (21) de celle-ci, et une branche supérieure (49) est disposée à angle droit par rapport à la branche inférieure (47) et s'étend donc substantiellement parallèlement au côté composants (17) de la carte de circuits imprimés (5),
**caractérisé en ce que** le contact par pression (39) est conçu de telle sorte que dans un état enfoncé dans la carte de circuits imprimés (5), il est adjacent au côté composants (17) par une branche supérieure (49).

2. Module de commande électronique selon la revendication 1, dans lequel la partie de connexion (19) du composant électrique (3) et la contrepartie de connexion (20) du contact par pression (39) sont réalisées avec du cuivre.

3. Module de commande électronique selon la revendication 1 ou 2, dans lequel la partie de connexion (19) du composant électrique (3) et au moins une partie partielle de la contrepartie de connexion (20) du contact par pression (39) sont disposées parallèlement au côté composants (17) de la carte de circuits imprimés (5).

4. Module de commande électronique selon l'une quelconque des revendications 1 à 3, dans lequel l'assemblage par soudure (43) entre la partie de connexion (19) du composant électrique (3) et la contrepartie de connexion (20) du contact par pression (39) est recouvert d'un matériau électriquement conducteur (37).

5. Module de commande électronique selon l'une quelconque des revendications 1 à 4, présentant en outre une platine de support (26) en matière plastique qui est disposée sur la carte de circuits imprimés (5) au niveau d'une surface à l'opposé du côté composants (17) .

6. Module de commande électronique selon la revendication 5, dans lequel la platine de support (26) présente de manière adjacente à une zone dépassant de la carte de circuits imprimés (5) d'un contact par pression (39) un trou borgne (33) recevant cette zone.

7. Module de commande électronique selon l'une quelconque des revendications 1 à 6, dans lequel la piste conductrice (16) de la carte de circuits imprimés (5) est adjacente au contact par pression (39) dans une zone interne de l'ouverture (21) et établit le contact électrique avec la contrepartie de connexion (20) du contact par pression (39).

8. Procédé de fabrication d'un module de commande électronique (1), en particulier pour une commande de boîte de vitesses, comprenant les étapes consistant à :
prévoir une carte de circuits imprimés (5) ayant un côté composants (17) et des pistes conductrices (16) ;
prévoir au moins un composant électrique (3) ayant au moins une partie de connexion (19) électriquement conductrice ;
le procédé comprenant en outre les étapes consistant à :
enfoncer un contact par pression (39) dans une ouverture (21) dans la carte de circuits imprimés (5) de façon à l'immobiliser mécaniquement sur la carte de circuits imprimés (5) et à établir par une zone partielle, enfoncée dans la carte de circuits imprimés, d'une contrepartie de .connexion (20) électriquement conductrice du contact par pression (39) un contact à la fois mécanique et électrique avec une piste conductrice (16) de la carte de circuits imprimés (5), le contact par pression (39) étant réalisé de manière substantiellement rectangulaire de sorte qu'une branche inférieure (47) peut être introduite perpendiculairement au plan de la carte de circuits imprimés (5) dans l'ouverture (21) de celle-ci et une branche supérieure (49) est disposée à angle droit par rapport à la branche inférieure (47) et s'étend donc substantiellement parallèlement au côté composants (17) de la carte de circuits imprimés (5),
souder la partie de connexion (19) du composant électrique (3) à la contrepartie de connexion (20) du contact par pression (39),
**caractérisé en ce que** le contact par pression (39) est conçu de telle sorte que dans un état enfoncé dans la carte de circuits imprimés (5), il est adjacent au côté composants (17) par une branche supérieure (49).

9. Procédé selon la revendication 8, dans lequel la partie de connexion (19) du composant électrique (3) est soudée à la contrepartie de connexion (20) du contact par pression (39) au moyen d'un laser (41).

10. Procédé selon la revendication 9, dans lequel le laser (41) émet une lumière laser verte pour la soudure.

11. Procédé selon la revendication 9 ou 10, dans lequel le laser (41) présente un rendement lumineux laser en mode de fonctionnement continu de moins de 500 W, de préférence de moins de 200 W.
